(19) Europäisches Patentamt
European Patent Office
Office européen des brevets

(11) **EP 3 683 537 A1**

(12) **EUROPEAN PATENT APPLICATION**

(43) Date of publication:
**22.07.2020  Bulletin 2020/30**

(51) Int Cl.:
**G01B 7/00** *(2006.01)*  **G01D 5/14** *(2006.01)*
**G01R 33/12** *(2006.01)*  **H01L 29/66** *(2006.01)*
**H01L 43/00** *(2006.01)*

(21) Application number: **19382032.1**

(22) Date of filing: **18.01.2019**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicants:
• **Fundació Institut Català de Nanociència i
Nanotecnologia**
**08193 Bellaterra (ES)**
• **Institució Catalana de Recerca i Estudis Avançats**
**08010 Barcelona (ES)**

(72) Inventors:
• **CUPPENS, Jo**
**E-3723 Guigoven (BE)**
• **COSTACHE, Marius Vasile**
**E-08201 Sabadell (ES)**
• **SIERRA GARCÍA, Juan Francisco**
**E-08023 Sabadell (ES)**
• **VALENZUELA, Sergio Osvaldo**
**E-08173 Sant cugat del Valles (ES)**

(74) Representative: **ABG Intellectual Property Law,
S.L.**
**Avenida de Burgos, 16D**
**Edificio Euromor**
**28036 Madrid (ES)**

(54) **DISPLACEMENT SENSOR**

(57)    A displacement sensor and a method for detecting displacement are disclosed. The displacement sensor comprises a lateral spin valve device, a movable member and a measuring device, wherein the movable member comprises a non-magnetic arm and a magnetic element located at an end of the arm.

FIG. 1

# Description

## TECHNICAL FIELD OF THE INVENTION

The present invention belongs to the field of displacement sensors and, more particularly, to the field of displacement sensors with a resolution from micrometers to sub-nanometers.

## BACKGROUND OF THE INVENTION

Detecting and measuring displacements in the micrometer to sub-nanometer range is currently achieved by using systems such as microactuators, light interferometers and inductance or capacitance-based measurements.

In interferometers, a laser irradiates light in a moving object. The phase difference between the incident and the reflected light is modified according to the moving object. In order to perform inductance-based measurements derived from said movement, a moving magnetic rod element is inserted in an excitation coil, which is connected to a detection coil. Then, the moving magnetic rod produces a phase difference between the excitation coil and the detection coil which is proportional to the displacement amount. Similar displacement measurements are carried out by changing the distance, or overlap, of capacitor plates.

Those displacement sensor technologies possess a resolution in the range of nanometers. However, they require large-size, heavy instrumentation and provide slow response speeds due to the high impedance electronics. In the case of current technologies such as microactuactors and displacement sensors based on laser interferometry, they have large-size and require complex instrumentation. In the case of displacement sensors based on inductance and capacitance measurements, the response speed is limited to about tens of kHz, due to the low speed and high impedance electronics used to detect the displacement amount.

Document US2004/0123677A1 discloses a displacement sensor with nanometer sensitivity comprising high impedance circuitry. Documents EP0064789A2 and US4715706 disclose displacement sensors with nanometer sensitivity comprising complex and heavy designs, respectively based in optical interferometry (EP0064789A2) and in laser Doppler Effect (US4715706).

Thus, there is a need for an improved displacement sensor for detecting the displacement of a moving object with resolution from micrometers to sub-nanometers.

## SUMMARY OF THE INVENTION

The present invention provides a solution for the aforementioned problems, by a displacement sensor according to claim 1 and a method for detecting displacements according to claim 12. In the dependent claims, preferred embodiments of the invention are defined.

In a first inventive aspect, the invention provides a displacement sensor comprising a lateral spin valve device supported by an electrically insulating substrate, a movable member and a measuring device.

According to the invention the lateral spin valve device comprises a paramagnetic strip extended along a longitudinal direction and a first, a second, a third and a fourth electrode consecutively arranged on the strip along the longitudinal direction. In other words, the second and third electrodes are located on the strip between the first and fourth electrodes according to the longitudinal direction.

The first and fourth electrodes are made of metal and the second and third electrodes are made of a spin-sensitive material, typically a ferromagnetic metal, such as iron, cobalt, nickel or alloys between them such as CoFe, CoFeB or FeNi.

The movable member comprises a non-magnetic arm and a magnetic element located at an end of the arm. The movable member is configured to be moved between a first position where the magnetic element placed at the end of the arm is located outside the strip, and a second position where the magnetic element is located over the strip between the second and the third electrodes.

That is, the first position of the movable member will be understood as a position where the orthogonal projection of the magnetic element on the plane containing the strip does not overlap the strip. The second position of the movable member will be understood as a position where the orthogonal projection of the magnetic element on the plane containing the strip overlaps the strip.

The measuring device is connected between the third and the fourth electrode and is configured to measure the voltage drop between said third and fourth electrode.

In a preferred embodiment, the second and third electrodes have an elongated shape in order to define the magnetization direction of said electrodes in-the plane and along the longitudinal axis of the electrodes.

When the first and the second electrodes are connected to a current source and are fed with current, preferably alternating current, the second electrode acts as a spin polarizer of the electric current due to its spin-splitting bands. Such spin-polarized current creates a spin accumulation beneath the second electrode. The spins then propagate in the form of a pure spin current along the paramagnetic strip. This spin current can be detected remotely by measuring the voltage between the third and the fourth electrodes by means of a measuring device. The measured voltage depends on the relative orientation of the magnetizations of the second and the third electrode and on the projection of the spin momentum direction along the magnetization direction of the third electrode. The position of the magnetic element of the movable member over the strip has also an effect on the measured voltage, due to the effect of the magnetic field generated by the magnetic element of the movable member on the spin current. The displacement sensor according to the invention allows detecting the displacement of the movable member itself and/or of an element coupled to the movable member based on the measured voltage, current and/or resistance. The detection of a displacement performed by the present device allows the determination of the value of the mentioned displacement according to the measured electric value.

Advantageously, the present invention provides a small-size, light and highspeed electronic response displacement sensor for detecting the displacement of a moving element with a resolution down to sub-nanometer.

Hereafter, the region of paramagnetic strip which is comprised between the second and the third electrodes will be called spin channel. The spin channel transports the spin current from the second electrode, which acts as spin injector, to the third electrode, which acts as spin detector. The spin channel is the active region of the lateral spin valve device where the pure spin current propagates. In an embodiment the distance between the second and the third electrode, that is, the spin channel length, is from 100 nanometers to 10 micrometers.

In an embodiment the displacement sensor further comprises a coupling element having a first end coupled to the movable member and a second end configured to be coupled with an element the displacement of which is to be detected. In a preferred embodiment the coupling element comprises a compression helical spring, wherein in a use situation of the displacement sensor the spring has a first end coupled to the movable member and a second end coupled to the element the displacement of which is to be detected.

In an embodiment the displacement sensor comprises a voltmeter as the measuring device, the voltmeter being connected between the third and the fourth electrodes and configured to measure the voltage drop between the third and the fourth electrodes. This voltage drop is also called spin signal.

In an embodiment the distance between the second and the third electrode is smaller than the spin relaxation length of the material of the paramagnetic strip. The spin relaxation length is defined as the distance travelled by spins without suffering scattering, i.e. the distance travelled coherently.

In an embodiment the displacement sensor further comprises an amplifier electrically connected to the measuring device which measures the spin signal. Advantageously, this embodiment enhances the sensitivity of the measurements.

In an embodiment the displacement sensor comprises a current source connected to the first and the second electrode, such as a battery. Preferably, the current source is an alternating current source.

In an embodiment the shape of the magnetic element is such that the magnetic field generated by the magnetic element points in a direction perpendicular to the plane containing the strip, i.e. the same plane wherein the spin channel is contained. In a preferred embodiment the magnetic element has a pyramidal shape with the apex pointing to the plane of the strip, a frusto-conical shape with the apex pointing to the plane of the strip, a conical shape with the apex pointing to the plane of the strip or a slab shape. Preferably, the magnetic element is a slab made of a magnetic material exhibiting perpendicular magnetic anisotropy.

Preferably, the magnetic field generated by the magnetic element is in the range of 50-500 mT, preferably 50-200 mT and more preferably 80-120 mT, being the optimal value 100 mT.

In an embodiment the magnetic element is dimensioned such that its width (i.e. the size of the magnetic element along the longitudinal direction of the strip) is smaller than the spin channel length and whereas its length (i.e. size of the magnetic element along the direction transversal to the longitudinal direction of the strip) is of the same order as the spin channel width and such that the magnetic field generated by the magnetic element is in the range of 50-500 mT, preferably 50-200 mT and more preferably 80-120 mT, being the optimal value 100 mT.

In an embodiment the second and third electrodes have an elongated shape and are arranged parallel one to another and transversally to the longitudinal direction of the strip.

In an embodiment the second and third electrodes have an elongated shape, the second electrode is extended along a first axis and the third electrode is extended along a second axis, wherein the first and second axis form a first angle ($\alpha$). In an embodiment the first angle ($\alpha$) is 90° and the first axis and the second axis each forms an angle of 45° with the longitudinal direction of the strip. Advantageously, the configuration where the second electrode and the third electrode form an angle of 90° maximizes the sensitivity or resolution of the displacement sensor to sub-nanometer displacement amounts.

In an embodiment the first and fourth electrodes are made of titanium, gold, or palladium.

In an embodiment the second and third electrodes are made of iron, cobalt, nickel or any alloy between them, preferably, CoFe, CoFeB or FeNi.

The use of ferromagnetic materials for the second and third electrodes enables the injection of spins into the lateral spin valve device at the second electrode as well as the detection at the third electrode of the spins propagated along the spin channel, i.e. along the distance separating the second and third electrodes.

In an embodiment the material of the paramagnetic strip has a spin relaxation length in the order of 100 nanometers or greater. For example, copper, silver and aluminium strips with spin relaxation lengths in the order of hundreds of nanometer at room temperature can be utilized as the material of the strip.

In a preferred embodiment the strip is made of a material with a spin relaxation length in the order of micrometer or greater). In a preferred embodiment the strip is made of graphene. Graphene is preferred because of its large spin relaxation length, in the order of tens of micrometers at room temperature. Furthermore, graphene has the advantage of allowing reducing the device thickness down to atomic scales.

In an embodiment the whole substrate is made of an electrically insulating material, typically silicon oxide.

In an embodiment the electrical insulating substrate comprises an electrically insulating layer and the strip is located on the electrically insulating layer. In an embodiment the substrate is made of silicon and the electrically insulating layer is made of silicon oxide. In an embodiment the thickness of the electrically insulating layer is between 100 nanometers and 1 micrometers.

In a second inventive aspect, the invention provides a method for detecting displacement, the method comprising the following steps:

> a) providing a displacement sensor according to any of the embodiments of the first inventive aspect,
> b) injecting a current between the first and the second electrodes,
> c) measuring the voltage drop between the third and the fourth electrodes,
> d) determining the resistance based on the values of the injected current and the measured voltage drop, and
> e) detecting a displacement of the movable member based on a change of the determined resistance.

The method according to the invention may detect the displacement due to the movement of the movable member itself and/or the movement of an element coupled to the arm of the movable member.

In an embodiment the method further comprises determining the displacement of the movable member using a predefined relation between the resistance and the displacement. In an embodiment the predefined relation is a mathematical expression or a graphical plot.

In an embodiment wherein the second and third electrodes have an elongated shape and are arranged parallel one to another and transversally to the longitudinal direction of the strip, the predefined relation, assuming full spin dephasing, is

$$R = R_0 \left(1 - \frac{d}{w}\right),$$

$R$ being the resistance, $R_0$ being the resistance value in the first position of the movable member, $w$ being the width of the strip in the region between the second and the third electrode, i.e. the spin channel width, and $d$ being the displacement of the movable member.

In an embodiment wherein the second electrode is extended along a first axis and the third electrode is extended along a second axis, wherein the first and second axis form an angle of 90° and wherein the first axis and the second axis each forms an angle of 45° with the longitudinal direction of the strip, the predefined relation is

$$R = B \frac{l_m}{c \cdot w} S \cdot d$$

wherein $R$ is the resistance, $B$ is the magnetic field generated by the magnetic element, $c$ is the distance between the second and the third electrode, $l_m$ is the width of the magnetic element, $w$ is the width of the strip in the region between the second and the third electrode, $S$ is the sensitivity of the displacement sensor and d is the displacement of the movable member.

In a particular embodiment, the displacement identified by the changes in the resistance values is monitored by means of a processor.

In a third inventive aspect a displacement detecting system comprises a displacement sensor according to any of the embodiments of the first inventive aspect and a processor. The processor is configured for performing the steps d) and e) of the method according to any of the embodiments of the second inventive aspect.

All the features described in this specification (including the claims, description and drawings) and/or all the steps of the described method can be combined in any combination, with the exception of combinations of such mutually exclusive features and/or steps.

## DESCRIPTION OF THE DRAWINGS

These and other characteristics and advantages of the invention will become clearly understood in view of the detailed description of the invention which becomes apparent from a preferred embodiment of the invention, given just as an example and not being limited thereto, with reference to the drawings.

> Figure 1 shows a top-view of a displacement sensor according to a first embodiment of the invention with the movable member placed in a first position.
>
> Figure 2 shows a top-view of the displacement sensor of figure 1 with the movable member placed in a second position.
>
> Figure 3 shows a cross-section of the displacement sensor of figure 1.
>
> Figure 4 shows a view of the movable member according to an embodiment of the displacement sensor.

Figure 5 shows a diagram showing the response of resistance measured between the third and the fourth electrodes of the displacement sensor of figure 1 when the movable member is displaced in a direction transversal to the longitudinal direction of the strip.

Figure 6 shows a top-view of a displacement sensor according to a second embodiment of the invention.

Figure 7 shows a diagram showing the response of resistance measured between the third and the fourth electrodes of the displacement sensor of figure 6 when the movable member is displaced in a direction transversal to the longitudinal direction of the strip.

## DETAILED DESCRIPTION OF THE INVENTION

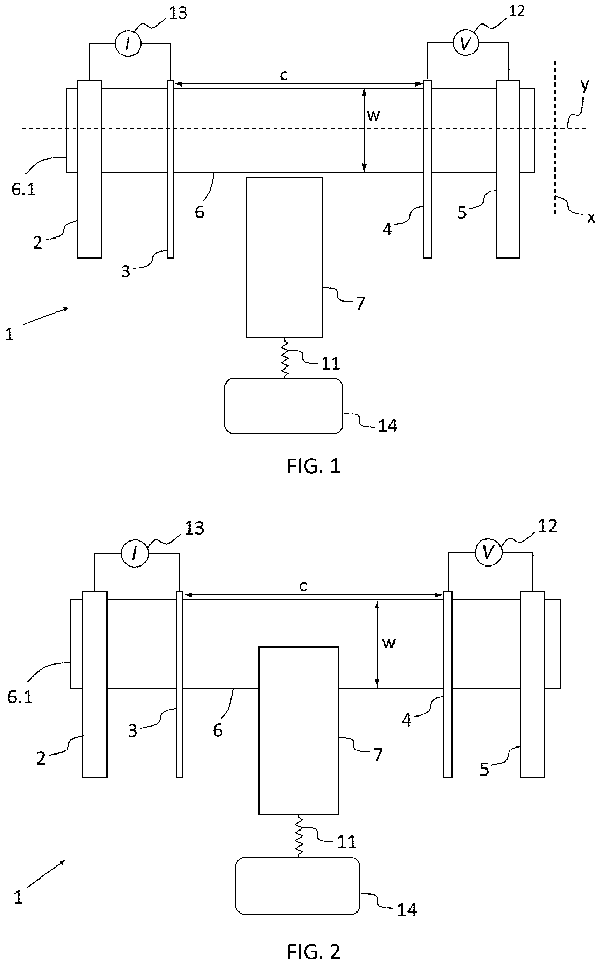

Figures 1 to 3 show a displacement sensor according to a first embodiment of the invention.

The displacement sensor according to the invention comprises a lateral spin valve device supported by an electrically insulating substrate (10), and a movable member (7).

The lateral spin valve device comprises a paramagnetic strip (6) extended along a longitudinal direction (y) and a first (2), a second (3), a third (4) and a fourth (5) electrode consecutively arranged on the strip (6) along the longitudinal direction (y).

The strip (6) is made of a paramagnetic material and comprises a first end (6.1). The electrodes (2, 3, 4, 5) are attached to the strip (6) and are spaced one from another. The second (3) and third (4) electrodes are located on the strip (6) between the first (2) and fourth (5) electrodes. As visible in figure 1, the four electrodes (2, 3, 4, 5) are arranged such that:

- the first electrode (2) is closer to the first end (6.1) of the strip (6) than the second electrode (3),
- the second electrode (3) is closer to the first end (6.1) of the strip (6) than the third electrode (4),
- the third electrode (4) is closer to the first end (6.1) of the strip (6) than the fourth electrode (5).

The first (2) and the fourth (5) electrodes are made of metal, preferably of a metal selected from titanium, gold and palladium. The second (3) and the third (4) electrodes are made of ferromagnetic metal, preferably of soft ferromagnetic metal, such as cobalt or a cobalt alloy, e.g. CoFe, CoFeB. As it can be appreciated in the figures, the four electrodes (2, 3, 4, 5) have an elongated shape in this embodiment.

In the embodiment of figures 1 to 3 the displacement sensor further comprises a voltmeter (12) and an alternating current source (13). The current source (13) is connected to the first (2) and the second (3) electrodes. The voltmeter (12) is connected between the third (4) and the fourth (5) electrodes and is configured to measure the voltage drop between the third (4) and the fourth (5) electrodes. Preferably, the voltmeter has a resolution in the measurement in the range of nanovolts.

The movable member (7) comprises a non-magnetic arm (8) and a magnetic element (9) located at an end (8.1) of the arm (8). The movable member (7) is configured to be moved between a first position where the magnetic element (9) is located outside the strip (6), and a second position where the magnetic element (9) is located over the strip (6) between the second (3) and the third (4) electrodes. Figures 1 and 2 show a top-view of the displacement sensor with the movable member placed in the first and in the second position, respectively.

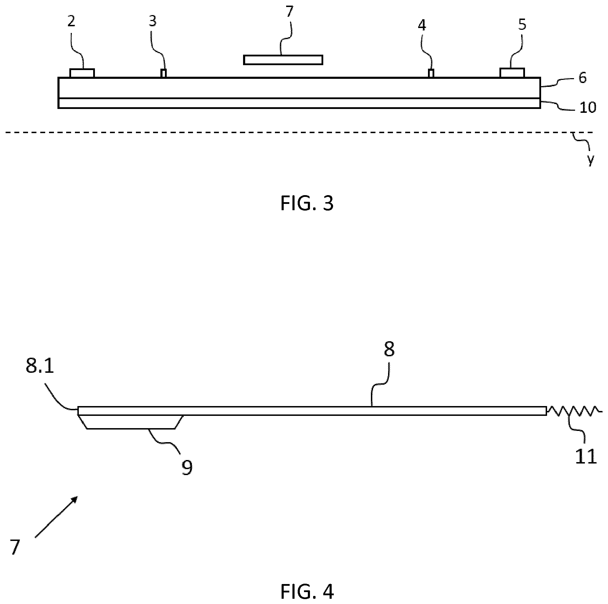

Figure 4 shows a view of the movable member according to an embodiment of the displacement sensor. In this embodiment the magnetic element (9) is shaped and dimensioned so that it generates a magnetic field with a component perpendicular to the plane where the strip (6) lies on. For example, a slab made of a sufficiently thin magnetic material with perpendicular magnetic anisotropy may be utilized as magnetic element. In this embodiment a coupling element (11) is coupled to the movable member (7) for coupling with an element the displacement of which is to be detected and/or measured. In this embodiment the coupling element (11) is a compression helical spring.

The displacement sensor according to the invention is based on low impedance resistive measurements. Some displacement sensors according to the state of the art measure capacity and require the use of high impedance circuitry, thus being intrinsically slower. A current biased flowing from the first electrode (2) to the second electrode (3) is spin-polarized due to the ferromagnetic nature of the second electrode (3). This configuration creates a spin accumulation beneath the second electrode (3) that diffuses away in a pure spin current flowing along the longitudinal direction (y) of the strip (6), which in the view of figures 1 and 2 corresponds to leftward and rightward direction. The spin current is detected by the third electrode (4) by measuring the voltage drop between the third (4) and the fourth (5) electrodes. The electrical detection is called non-local because the biased current I is separated from the detection region so that the current I does not flow directly in the voltage detection region, *i.e* between the third (4) and fourth (5) electrodes.

The resistance R of the non-local configuration is defined as R =V/I, V being the measured voltage between the third (4) and the fourth (5) electrode and I being the injected current supplied with the current source (13). When the arm (8) of the movable member (7) is placed over the strip (6) in a transversal axis direction (x), it influences the spin current flowing across the strip and the resistance R between the third (4) and the fourth (5) electrodes is changed due to the presence of the magnetic field generated by the magnetic element (9) placed at one end (8.1) of the arm (8). The displacement amount of the magnetic element (9) in a direction transversal (x) to the strip (6), and thus transversal to the spin channel, is detected by measuring the changes in the voltage at the detection region.

Preferably, the strip (6) is made of aluminum, silver, copper or graphene. Graphene is particularly preferred due to its pristine properties, exhibiting high electrical mobility and allowing spin transport over distances in the range of tens of micrometer at room temperature. In a preferred embodiment the width (w) of the strip (6) in the region between the second (3) and the third (4) electrode is comprised in the range from 1 micrometer to 1 millimeter.

In this example, the first (2) and the fourth (5) electrodes are attached to the strip (6) in direct contact with the strip, whereas a tunnel barrier (not shown) is arranged between each of the second (3) and the third (4) electrode and the strip (6). Advantageously, the tunnel barrier allows suppression of the impedance mismatch between the ferromagnetic electrodes (3, 4) and the strip (6). Also, better polarization of spins is achieved and the electrical current supplied by the current source (13) to the second electrode can be small (in the order of 1 $\mu$A). In an embodiment the strip is made of graphene and the tunnel barrier is made of a dielectric material selected from aluminum oxide, magnesium oxide, amorphous carbon, strontium oxide and titanium oxide. In other embodiments the second and the third electrode may be attached to the strip in direct contact with the strip, i.e. without a tunnel barrier.

In the present example, the values of the current I are between 1- 2 micro amperes in the event of having a tunnel barrier, whereas the values of the current I are between 10 - 20 micro amperes in the event of not having the mentioned tunnel barrier.

In an embodiment wherein the strip is made of aluminium, silver or copper, the spin channel length (c) is less than or equal to 100 nanometers (c $\le$ 100 nanometers). In an embodiment wherein the strip is made of graphene, the spin channel length (c) is less than or equal to 10 micrometers (c $\le$ 10 micrometers).

The displacement sensor (1) according to the embodiment of figures 1 to 3 comprises a coupling element (11) having a first end coupled to the movable member (7) and a second end coupled with an element (14) the displacement of which is to be detected and/or measured. In this embodiment the coupling element (11) is a compression helical spring. In other embodiments the coupling between the movable member (7) and the element (14) the displacement of which is to be detected and/or measured can be performed using other types of coupling elements.

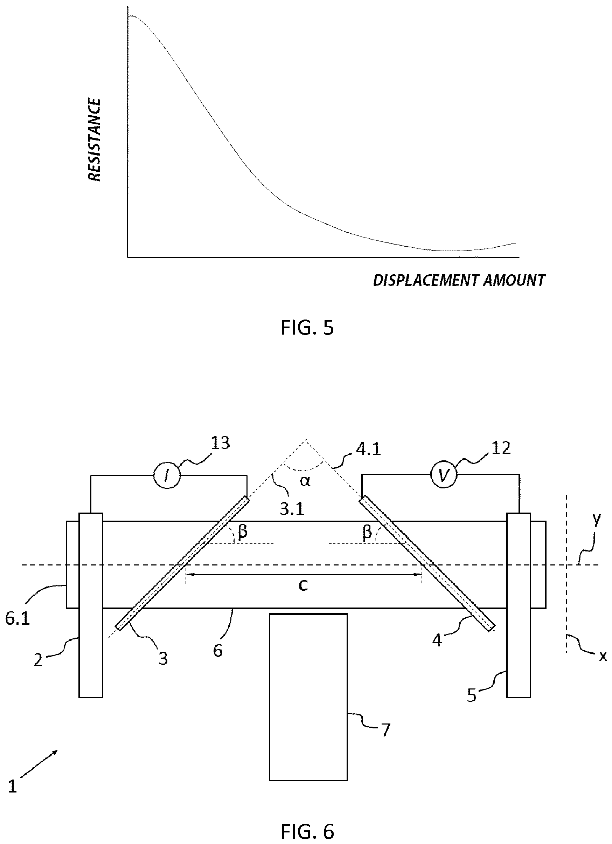

In the displacement sensor according to the embodiment of figures 1 to 3 the second electrode (3) and the third electrode (4) are arranged parallel to each other and forming an angle of 90 degrees with respect to the longitudinal direction (y) of the strip (6). Figure 5 shows a diagram showing the response of resistance between the third (4) and the fourth (5) electrodes of the displacement sensor of this embodiment when the movable member is displaced in a direction (x) transversal to the longitudinal direction (y) of the strip.

In figure 5 the abscissa represents the displacement amount of the arm (8) and the ordinate represents the resistance. A direction of increasing the displacement amount is a direction of increasing the position of the magnetic element (9) over the strip (thus over the spin channel). A maximum resistance value is obtained when the magnetic element (9) is out of the spin channel, which corresponds to the situation of zero magnetic field applied to the spin channel, whereas a minimum resistance value corresponds to the position when the magnetic element (9) is placed at the middle of the width of the strip, creating a magnetic field enough to de-phase the spin signal.

In this embodiment wherein the second (3) and third (4) electrodes have an elongated shape and are arranged parallel one to another and transversally to the longitudinal direction (y) of the strip, the relation between the resistance and the displacement of the movable member assuming full spin dephasing can be stated as:

$$R \sim R_0 \left(1 - \frac{d}{w}\right) + O(d^2),$$

wherein R is the resistance, $R_o$ is the resistance value in the first position of the movable member (i.e. when the magnetic element is located out of the spin channel and the magnetic field applied to the spin channel is zero), w is the width of the strip in the region between the second and the third electrode (i.e. the width of the spin channel), and d is the displacement of the movable member.

Thus, in a first order approximation the relation between the resistance and the displacement of the movable member can be stated as:

$$R = R_0 \left(1 - \frac{d}{w}\right).$$

Typical values of $R_0$ and w are 10$\Omega$ and 1 micrometer respectively.

Figure 6 shows a top-view of a displacement sensor according to a second embodiment of the invention. In this embodiment the second (3) and third (4) electrodes have an elongated shape and are extended along a first axis (3.1) and along a second axis (4.1), respectively, the first axis (3.1) and the second axis (4.1) being arranged forming an angle ($\alpha$) of 90 degrees between them and an angle ($\beta$) of 45 degrees with respect to the longitudinal direction (y) of the strip (6). In this embodiment, the spin channel length (c) is defined as the distance between the second (3) and the third (4) electrode at the middle of the spin channel width.

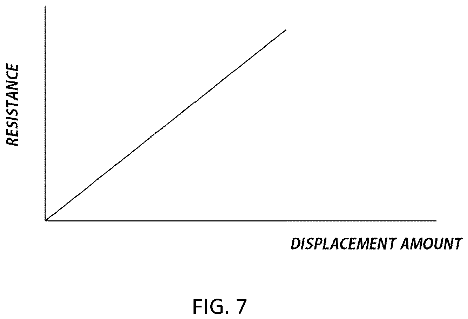

Advantageously, this embodiment provides a higher sensitivity about zero magnetic fields, which corresponds to a position of the moving magnetic element (9) out of the spin channel region, which corresponds to the situation of zero magnetic field applied to the spin channel. In this case, when the arm (8) of the movable member (7) is displaced across the strip width, the resistance measured between the third (4) and the fourth (5) electrodes changes according to the diagram shown in figure 7. Figure 7 represents the displacement amount of the arm (8) in the abscissa and the resistance in the ordinate. A direction of increasing the displacement amount is a direction of increasing the position of the magnetic element (9) over the strip (6) (thus inside the spin channel). Zero resistance value is obtained when the magnetic element (9) is out of the spin channel, whereas a maximum resistance value corresponds to the position where the magnetic element (9) is displaced at the middle of the width of the strip (6).

In this embodiment wherein the second electrode is extended along a first axis (3.1) and the third electrode is extended along a second axis (4.1), wherein the first and second axis form an angle ($\alpha$) of 90° and wherein the first axis and the second axis each forms an angle ($\beta$) of 45° with the longitudinal direction of the strip, the relation between the resistance (R) and the displacement (d) of the movable member can be stated as:

$$R = B \frac{l_m}{c \cdot w} S \cdot d$$

Particularly, $B$ represents the magnetic field generated by means of the magnetic element, being in the present example an estimated value of 100 mT.

$c$ represents the length of the spin channel (in the present example 10 micrometers), $l_m$ is the width of the magnetic element (in the present example between 1-10 micrometer).

w represents the width of the spin channel, being its value in the present example 1 micrometer.

Finally, S is the sensitivity of the sensor (1), measured in $\Omega/T$, being the sensor (1) previously calibrated. A typical value of sensitivity for the present example of the sensor (1) is 300 $\Omega/T$.

The displacement sensor according to the invention can detect and measure the displacement amount of a moving object with a resolution from micrometers to sub-nanometers by a simple electrical device suitable for fast-speed response, small-sized and lightweight formation. Typical resistance values obtained with the displacement sensor according to the invention are about 5 Ohm when graphene is used as strip material. This resistance value corresponds to voltages at the third (4) and fourth (5) electrodes of about 50 microvolts for bias currents of about 10 micro amperes. Typical noise level with standard electronics in such displacement sensor is about 10 nanovolts, which leads to a signal to noise ratio of 5000. The transversal displacement of the movable member (7) across the width of the strip (spin channel) - whose preferred width might range from 1 micrometer up to 1 millimeter, produces a change in the detected voltage for displacements as from 0.2 nanometers to 0.2 micrometers in strips of 1 micrometer to 1 millimeter width, respectively.

**Claims**

1. A displacement sensor (1) comprising:

   a lateral spin valve device supported by an electrically insulating substrate,
   a movable member (7), and
   a measuring device (12);
   wherein the lateral spin valve device comprises a paramagnetic strip (6) extended along a longitudinal direction (y) and a first (2), a second (3), a third (4) and a fourth (5) electrode consecutively arranged on the strip (6) along the longitudinal direction (y);
   wherein the first (2) and fourth (5) electrodes are made of metal and the second (3) and third (4) electrodes are made of ferromagnetic metal;
   wherein the movable member (7) comprises a non-magnetic arm (8) and a magnetic element (9) located at an end (8.1) of the arm (8) and wherein the movable member (7) is configured to be moved between:

   • a first position where the magnetic element (9) is located outside the strip (6), and
   • a second position where the magnetic element (9) is located over the strip (6) between the second (3) and the third (4) electrodes; and

   wherein the measuring device (12) is connected between the third (4) and the fourth (5) electrode and is configured to measure the voltage drop between said third (4) and fourth (5) electrode.

2. A displacement sensor according to claim 1, wherein the distance (c) between the second (3) and third (4) electrode is smaller than the spin relaxation length of the material of the strip (6).

3. A displacement sensor according to any of the previous claims, further comprising a current source (13) electrically connected to the first (2) and the second (3) electrodes.

4. A displacement sensor according to any of the previous claims, wherein the magnetic element (9) is made of a magnetic material in the shape of a slab, pyramidal shaped, conical shaped or frusto-conical shaped.

5. A displacement sensor according to any of the previous claims, wherein the second (3) and third (4) electrodes are arranged parallel to each other and transversal to the longitudinal direction (y) of the strip (6).

6. A displacement sensor according to any of claims 1 to 4, wherein the second electrode (3) is extended along a first axis (3.1) and the third electrode (4) is extended along a second axis (4.1), wherein the first (3.1) and the second (4.1) axis form a first angle ($\alpha$).

7. A displacement sensor according to claim 6, wherein the first angle ($\alpha$) is 90° and wherein the first axis (3.1) and the second axis (4.1) each forms an angle ($\beta$) of 45° with the longitudinal direction (y) of the strip.

8. A displacement sensor according to any of the previous claims, wherein the strip (6) is made of a material having a spin relaxation length of 100 nanometers or greater, preferably aluminum, silver, copper or graphene, and more preferably graphene.

9. A displacement sensor according to any of the previous claims wherein the measuring device is a voltmeter (12).

10. A displacement sensor according to any of the preceding claims, further comprising an amplifier electrically connected between the third electrode (4) and the measuring device (12).

11. A sensor according to any of the previous claims, further comprising a coupling element (11) having a first end coupled to the movable member (7) and a second end configured for coupling with an element the displacement of which is to be measured, the coupling element preferably comprising a compression helical spring.

12. A method for detecting displacement, the method comprising the following steps:

   a) providing a displacement sensor (1) according to any of the previous claims,
   b) injecting an electric current between the first (2) and the second (3) electrodes,
   c) measuring the voltage drop between the third (4) and the fourth (5) electrodes,
   d) determining the resistance based on the values of the injected current and the measured voltage drop, and
   e) detecting a displacement of the movable member based on a change of the determined resistance.

13. A method according to the previous claim, wherein the method further comprises determining the displacement of the movable member using a predefined relation between the resistance and the displacement, the predefined relation being preferably a mathematical expression or a graphical plot.

14. A method according to the previous claim, wherein the displacement sensor is according to claim 5 and wherein the predefined relation is

$$R = R_0 \left( 1 - \frac{d}{w} \right),$$

R being the resistance, $R_0$ being the resistance value in the first position of the movable member, $w$ being the width of the strip in the region between the second and the third electrode, and d being the displacement of the movable member.

15. A method according to claim 13, wherein the displacement sensor is according to claim 7 and wherein the predefined relation is:

$$R = B \frac{l_m}{c \cdot w} S \cdot d$$

wherein $R$ is the resistance, $B$ is the magnetic field generated by the magnetic element, $c$ is the distance between the second and the third electrode, $l_m$ is the width of the magnetic element, $w$ is the width of the strip in the region between the second and the third electrode, S is the sensitivity of the sensor (1) and d is the displacement of the movable member.

FIG. 1

FIG. 2

FIG. 3

FIG. 4

FIG. 5

FIG. 6

FIG. 7

Europäisches
Patentamt

European
Patent Office

Office européen
des brevets

**EUROPEAN SEARCH REPORT**

Application Number

EP 19 38 2032

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | US 2011/204886 A1 (SASAKI TOMOYUKI [JP] ET AL) 25 August 2011 (2011-08-25)<br>* paragraph [0047] - paragraph [0070]; figures 1-3 *<br>----- | 1-15 | INV.<br>G01B7/00<br>G01D5/14<br>G01R33/12<br>H01L29/66 |
| A | BORME J ET AL: "Magnetoresistive-based static tester for actuators",<br>JOURNAL OF APPLIED PHYSICS, AMERICAN INSTITUTE OF PHYSICS, US,<br>vol. 103, no. 7,<br>12 March 2008 (2008-03-12), pages 7F537-7F537, XP012110448,<br>ISSN: 0021-8979, DOI: 10.1063/1.2838342<br>* abstract; figure 1 *<br>----- | 1-15 | H01L43/00 |
| A | RIEGER G ET AL: "GMR sensors for contactless position detection",<br>SENSORS AND ACTUATORS A: PHYSICAL, ELSEVIER BV, NL,<br>vol. 91, no. 1-2, 5 June 2001 (2001-06-05), pages 7-11, XP027357281,<br>ISSN: 0924-4247<br>[retrieved on 2001-06-05]<br>* abstract; figures 1, 2, 4 *<br>----- | 1-15 | |

TECHNICAL FIELDS
SEARCHED (IPC)

G01B
G01D
G01R
H02N
H01L
G01C

The present search report has been drawn up for all claims

| Place of search | Date of completion of the search | Examiner |
|---|---|---|
| Munich | 27 May 2019 | Braun, P |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

..........................................................................

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 19 38 2032

This annex lists the patent family members relating to the patent documents cited in the above-mentioned European search report.
The members are as contained in the European Patent Office EDP file on
The European Patent Office is in no way liable for these particulars which are merely given for the purpose of information.

27-05-2019

| Patent document cited in search report | | Publication date | Patent family member(s) | | Publication date |
|---|---|---|---|---|---|
| US 2011204886 | A1 | 25-08-2011 | CN | 102194466 A | 21-09-2011 |
| | | | EP | 2372381 A1 | 05-10-2011 |
| | | | JP | 5338711 B2 | 13-11-2013 |
| | | | JP | 2011176012 A | 08-09-2011 |
| | | | US | 2011204886 A1 | 25-08-2011 |

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 20040123677 A1
- EP 0064789 A2
- US 4715706 A